Europäisches Patentamt

(19) European Patent Office

Office européen des brevets

(11) Publication number: **0 036 431**
**B1**

(12) **EUROPEAN PATENT SPECIFICATION**

(45) Date of publication of patent specification: **11.12.85**

(51) Int. Cl.⁴: **H 04 B 1/04**

(21) Application number: **80901808.8**

(22) Date of filing: **26.09.80**

(86) International application number:
**PCT/JP80/00224**

(87) International publication number:
**WO 81/00942 02.04.81 Gazette 81/08**

(54) TRANSMITTER HAVING A PHASE-LOCKED LOOP.

(30) Priority: **27.09.79 JP 123196/79**

(43) Date of publication of application:
**30.09.81 Bulletin 81/39**

(45) Publication of the grant of the patent:
**11.12.85 Bulletin 85/50**

(84) Designated Contracting States:
**DE FR GB SE**

(56) References cited:
**FR-A-2 298 226**
**JP-A-50 047 510**
**JP-A-51 051 209**
**JP-A-52 110 512**
**JP-A-53 041 916**
**US-A-3 393 380**
**US-A-3 644 831**
**US-A-3 882 424**
**US-A-4 052 672**

**Transistor Gijutsu, Vol. 13, No. 8 (1976-8) Kubo Daijiro "Oyo eno Approach PLL IC no Kisochishiki" P. 90-97 (Tokuni "Lock jino Tokusei" no Ko Sansho)**

(73) Proprietor: **TOYO COMMUNICATION EQUIPMENT CO.,LTD.**
**753, Koyato, Samukawa-machi**
**Koza-gun Kanagawa 253-01 (JP)**

(72) Inventor: **NAITO, Yukio**
**26-10, Ookayama 1-chome**
**Meguro-ku Tokyo 152 (JP)**
Inventor: **TAMURA, Masahide**
**10-1, Hamamidaira Chigasaki-shi**
**Kanagawa, 253 (JP)**
Inventor: **TAKAHASHI, Shigeo**
**Nishimiyaso, 7-5, Daigiri 1-chome**
**Fuzisawa-shi Kanagawa 251 (JP)**

(74) Representative: **Needle, Jacqueline et al**
**PAGE, WHITE & FARRER 5 Plough Place New Fetter Lane**
**London EC4A 1HY (GB)**

(56) References cited:
**PHILIPS TELECOMMUNICATIONS REVIEW vol. 36, no. 1, April 1978 Hilversum, NL F. van ENK et al.: "P-TMC Mobile/fixed equipment", pages 85-91**
**HORST GESCHWINDE EINFÜHRUNG IN DIE PLL-TECHNIK", Part 2 "Pll Technik in der Praxis" 1978, pages 38-94 Vieweg & Sohn, Braunschweig, DE**

## Description

The present invention relates to a transmitter having a phase synchronizing system.

In a mobile communication system using VHF or UHF band frequencies, it is common for the frequencies to be multichannel and wide band. In this case, there is a strong requirement to decrease the transmission strength of spurious waves and to decrease noises in sideband, especially in the transmitting output signal in order not to disturb other communication systems.

On the other hand, due to the multichannel requirement of the communication system, and as phase synchronizing type digital frequency synthesizers are easily obtainable, a very large number of frequencies are increasingly used as the signal source of the local oscillation frequency of the transmitter and the receiver.

A known device derives the local oscillation frequency signal source for the transmitter and for the receiver from a single phase synchronizing type frequency synthesizer and widens the frequency bandwidth. This device comprises a phase synchronizing type of digital frequency synthesizer a transmitter, a receiver, an antenna duplexer, and an antenna terminal. Further, the transmitter comprises a side step oscillator, a phase or frequency modulator a transmitting buffer amplifier, a frequency mixer, a bandpass filter, a preamplifier and a power amplifier. The receiver comprises a receiving buffer amplifier, a receiving high frequency portion, an intermediate frequency converter, an intermediate frequency bandpass filter and a demodulator as an ordinary form.

In this arrangement of the transmitter it is difficult to obtain a good signal having low noise and sufficiently suppressed spurious waves over a wide band at the transmitter output and it has both technical and manufacturing problems.

A similar transmitter is described in US—A—3 882 424 but this also has the problems suggested above.

According to the present invention there is provided a transmitter comprising a frequency mixer to one input of which is applied a frequency input signal, and to another input of which is applied an output of phase or frequency modulating means, the output from said frequency mixer being coupled to amplifying means by way of a bandpass filter, and wherein a phase synchronizing system is connected between said bandpass filter and said amplifying means, said phase synchronizing system comprising a phase detector coupled to a voltage controlled oscillator and having a feedback route from said voltage controlled oscillator to said phase detector, characterized in that said frequency input signal is an output of a phase synchronizing type digital frequency synthesizer, in that the phase synchronizing system comprises a series connection of the phase detector, a lowpass filter and the voltage controlled oscillator, the phase detector being connected to the bandpass filter and the voltage controlled oscillator being connected to the amplifying means, in that a first fixed frequency divider is connected between said phase synchronizing type digital frequency synthesizer and said frequency mixer, and in that a second fixed frequency divider is connected in the feedback route of said phase synchronizing system.

The present invention provides a high quality, wide band transmitter for FM radio equipment of the type having a multichannel simultaneous transmission and receiving system can easily be obtained in a miniaturized form and at low cost.

Embodiments of the preent invention will hereinafter be described with reference to the accompanying drawings, in which:—

Fig. 1 is a block diagram of conventional FM radio equipment for a multichannel simultaneous transmission and receiving system;

Fig. 2 is a block diagram of a digital frequency synthesizer of a phase synchronization type;

Fig. 3 is a block diagram of an FM radio transmitter,

Fig. 4 shows a block diagram of an embodiment of a transmitter of the present invention;

Fig. 5 shows a block diagram of a further embodiment of a transmitter of the invention,

Fig. 6 shows a block diagram of a further embodiment of a transmitter of the invention,

Fig. 7 is a block diagram showing an antenna duplexer;

Fig. 8 is a block diagram showing an embodiment of a modulator for the transmitter of Fig. 6,

Fig. 9 is a block diagram showing a further modification of the transmitter of Fig. 8;

Fig. 10 is a practical embodiment of FM radio equipment for a multichannel simultaneous transmission and receiving system using a transmitting system of the present invention; and

Fig. 11 is a further practical embodiment of FM radio equipment similar to Fig. 10 but incorporating modifications.

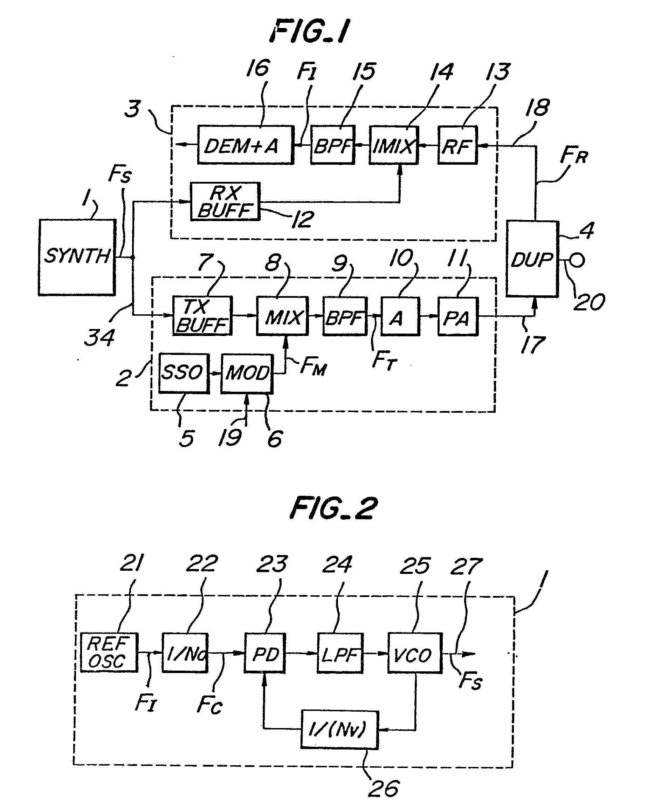

Fig. 1 is a block diagram of conventional FM radio equipment for a multichannel simultaneous transmitting and receiving system.

The device illustrated in Fig. 1 comprises a phase synchronizing type digital frequency synthesizer 1, a transmitter 2, a receiver 3, an antenna duplexer 4, and an antenna terminal 20. The transmitter 2 comprises a side step oscillator 5, a modulator (a phase or frequency modulator) 6, a transmitting buffer amplifier 7, a frequency mixer 8, a bandpass filter 9, a preamplifier 10, and a power amplifier 11. The receiver 3 comprises a receiving buffer amplifier 12, a receiving high frequency portion 13, an intermediate frequency converter 14, an intermediate frequency bandpass filter 15 and a demodulator 16 as an ordinary form.

The frequency relationship is given by the following formulae.

$$F_T = F_S + F_M \text{ or } F_T = F_S - F_M$$

$$F_R = I_S + F_I \text{ or } F_R = F_S - F_I$$

wherein;

$F_T$: output frequency of the output 17 of the transmitter

$F_R$: input frequency of the receiver input 18

$F_S$: frequency of the output 34 of the frequency synthesizer 1 of the phase synchronization type

$F_M$: output frequency of modulated wave of the modulator 6

$F_I$: center frequency of the intermediate frequency bandpass filter.

The operation is explained as follows. The output 34 of the phase synchronizing type digital frequency synthesizer 1 is divided into two branches, one of which is used as a signal source of the local oscillator of the transmitter 2 and the other one of which is used as that of the receiver 3. The output 34 supplied to the transmitter 2 is fed to an input of the frequency mixer 8 via the transmitting buffer amplifier 7. A modulated wave output frequency $F_M$ is also fed to the input of the frequency mixer 8 from the modulator 6, which has its input from the side step oscillator 5 and a modulation input signal 19. A frequency converted component from the mixer 8 is supplied to the bandpass filter 9, and only a desired output signal $F_T$ therein is selectively filtered out and is further amplified in the pre-amplifier 10. In the power amplifier 11 a desired output signal is obtained at the transmitter output 17. The component of the output 34 supplied to the receiver 3 is applied to an input of the intermediate frequency converter 14 via the receiving buffer amplifier 12. The receiver input signal $F_R$ is fed at 18 to an input of the intermediate frequency converter 14 via the high frequency portion 13, a frequency conversion is effected therein and among the converted output signals a desired output signal $F_I$ is selectively derived by the intermediate frequency bandpass filter 15 and a demodulated signal is obtained in the demodulator portion 16. (In the construction of a receiver, it is usual to design it as a double super heterodyne system by providing two, i.e. first and second, intermediate frequency bandpass filters, but this explanation is omitted since the detailed construction of the receiver is not concerned with the present invention).

The problem to be considered is the spurious waves and the noises in the sideband wave which are generated in or mixed into the transmission band of the output signal 17 of the transmitter 2.

We may consider at first the generation and mixing of spurious waves. For realizing a multichannel and wide band device a corresponding wide band is requested for a series of devices including the frequency mixer 8, the bandpass filter 9, the preamplifier 10, and the power amplifier 11, and among these, in the frequency mixer 8; an infinite number of combinations of frequencies expressed by the following conditional formula is derived at its output:

$$nF_S \pm mF_M$$

wherein; n and m are positive intergers.

Now, if we assume that a frequency $(F_S + F_M)$ among the above is the desired frequency $F_T$, then all the other frequencies are regarded as the spurious waves which should be suppressed or filtered out by the bandpass filter 9 in the succeeding stages.

When the desired bandwidth becomes wider, the probability of numbers of spurious waves produced by the combination of the higher order numbers of m and n and falling in the wandwidth increases accordingly and causes stronger spurious wave noises. In practice, suppressing the spurious waves produced inside the frequency mixer is in general done by adjusting either one of the inputs $F_S$ or $F_M$ at a considerably lower level than the others and using the frequency mixer 8 in a portion having good linearity characteristics in which the production of the spurious waves is comparitively low. However, if such "low level adjustment" is made, at the same time it is accompanied by a decrease of level difference between the signal level of the desired output wave of the frequency mixer 8 and the noise level already generated surrounding said output wave or mixing therewith, so that an increase of side wave noise by such noise level results.

Due to the above reasons, in a conventional transmitter 2 as shown in Fig. 1, the following technical practices have been considered for preventing generation of the spurious waves and for the suppression of the sideband wave noises: adjustment of the input level of the frequency mixer 8; making low passing loss of the bandpass filter 9; gain adjustment of the preamplifier 10 and the power amplifier 11; and selection of the modulated wave output frequency $F_M$ of the modulator 6 and that of output frequency $F_S$ of the phase synchronizing type digital frequency synthesizer 1 against the transmitting output frequency $F_T$.

However, up to the present an effective improvement in the characteristics has not yet been realized since the aforementioned various adjustments and the selection of $F_S$, $F_M$ and the relationship of the attenuation characteristics of the bandpass filter are relatively correlated to each other in a complex manner, and they may mutually cause difficulties such that the problems remain unsolved.

As an example, details of the phase synchronizing type digital frequency synthesizer 1 are shown in block form in Fig. 2. In this figure, there is a reference wave oscillator 21, a fixed frequency divider 22, a phase detector 23 in the main route, a lowpass filter 24, a voltage controlled oscillator 25, a variable frequency divider 26 in a feedback route, and an output 27.

In the frequency synthesizer 1 shown in Fig. 2, 23, 24, 25 and 26 are phase synchronized, and the frequency relation is given by the following known formula:

$$F_S = F_C \times N_V, \quad F_C = \frac{F_I}{N_O}$$

wherein;

$F_S$: frequency of the output 27

$F_I$: output frequency of the reference oscillator 21

$F_C$: output frequency of the fixed frequency divider 22

$N_O$: frequency dividing number of the fixed frequency divider 22

$N_V$: frequency dividing number of the variable frequency divider 26

Among the above, the three items, $F_I$, $F_C$, $N_O$ are generally fixed. $N_V$ may have a variation range corresponding to the channel number of the output frequency $F_S$, whereas if the frequency dividing number of the frequency divider 26 is varied as $N_V+1$, $N_V+2$, --- $N_V+n$ under a condition that the closed loop is in phase synchronism, then the output frequency $F_S$ varies $F_S+F_C$, $F_S+2F_C$ --- $F_S+nF_C$, respectively.

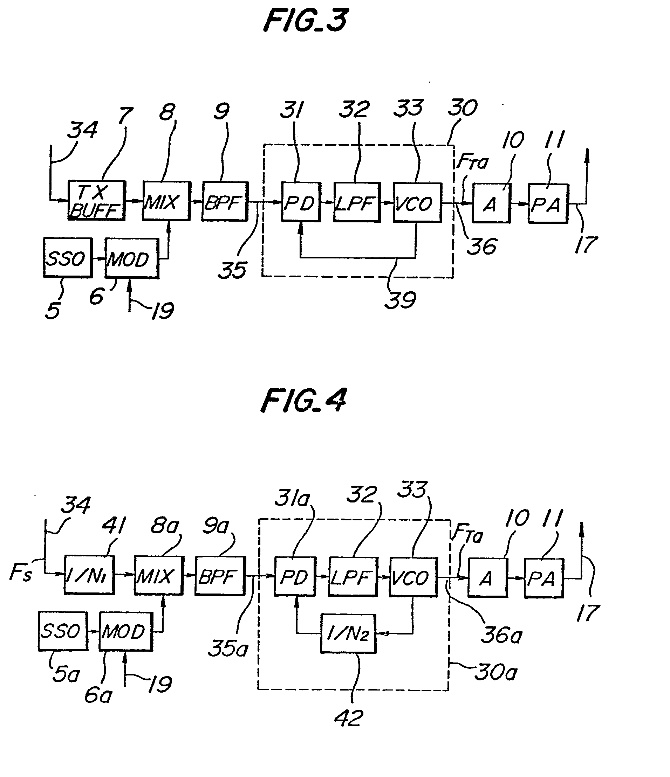

Fig. 3 shows a block diagram of an FM radio transmitter of a multichannel simultaneous transmitting and receiving system using a transmitting phase synchronizing system. In this figure, blocks having the same reference numeral as in Fig. 1 have the same function as those shown in Fig. 1. (This will equally be applied in the other figures). In the figure, a portion 30 depicted by a closed dotted line is the transmitting phase synchronizing system added to the conventional transmitter 2 shown in Fig. 1. The transmitting phase synchronizing system 30 comprises a phase detector 31, a lowpass filter 32, a voltage controlled oscillator 33 on a main route and a feedback route 39.

The operation of the transmitting phase synchronizing system 30 will now be explained.

The output frequency $F_T$ of the bandpass filter 9 and an output signal $F_{Ta}$ generated in the voltage controlled oscillator 33 are fed to the phase detector 31 and the phases of the signals are compared. The output signal of the phase detector 31 is applied to the lowpass filter 32 to remove spurious wave components and then to a control input terminal of the voltage controlled oscillator 33. This series loop circuit forms a negative feedback phase control system, and if the output frequency $F_T$ of the bandpass filter 9 coincides with the output frequency $F_{Ta}$ of the voltage controlled oscillator 33 (or if both the frequencies are the same; $F_T=F_{Ta}$), the output signal of the phase detector 31 becomes a dc component and this will control the phase of the oscillation frequency $F_{Ta}$ of the voltage controlled oscillator 33.

If the input signal 34 coming from the phase synchronizing type digital frequency synthesizer 1 is shifted from $F_S$ to $(F_S+F_C)$ as has been described in the foregoing, the output frequency of the bandpass filter 9 changes to $(F_T+F_C)$. The transmitting phase synchronizing system 30 follows such that a signal $(F_{Ta}+F_C)$ is obtained at the output 36. Simiarly if the input signal is switched to $(F_S+nF_C)$, a signal $(F_{Ta}+nF_C)$ can likewise be obtained at the output 36. As is known already, the transmitting phase synchronizing system 30 exhibits variable type band characteristics, having its bandpass characteristics of a certain bandwidth corresponding to the frequency response characteristics of the closed loop, and the center frequency thereof varies in accordance with the input signal $F_T$ at phase synchronizing condition from the input 35 to the output 36. Accordingly, if the bandwidth of this transmitting phase synchronizing system 30 is made as narrow as possible in the variation range of the input signal $F_T$, and in a range in which phase synchronization is sufficiently possible, and also is made not to influence the demodulated wave characteristics, the aforementioned spurious waves and the sideband noises may be sufficiently suppressed.

Now we may explain a possible method for narrowing the band of the passband whilst securing the phase synchronizing range of the transmitting phase synchronizing system 30.

Let us assume that the transmitting phase synchronizing system 30 is synchronized with the output frequency $F_T$ of the bandpass filter 9. When the output signal switches from $F_T$ to $F_T+nF_C$, instantaneously the frequencies go out of synchronization, and a beat signal of frequency $nF_C$ is produced at the output of the phase detector 31. If the cutoff frequency of the frequency response characteristics of the loop 30 is equal to $nF_C$ or is higher than that, the output frequency $F_{Ta}$ of the voltage controlled oscillator 33 is directly controlled by this beat signal to become $(F_{Ta}+nF_C)$, and again is phase synchronized. Accordingly, to realize the narrow bandwidth, at the same time as the cutoff frequency of the loop 30 is lowered, the oscillating frequency of the voltage controlled oscillator 33 is switched in, ganged with the variation of the frequency dividing number $N_V$ of the variable frequency divider 26 of the phase synchronizing type digital frequency synthesizer 1 shown in Fig. 2. The frequency of the beat signal produced at the output of the phase detector 31 is thereby lowered to be lower than the loop cutoff frequency. By this the intended narrow bandwidth of the transmitting phase synchronizing system 30 can be realized.

The transmitter which is shown in Fig. 3, and which includes the transmitting phase synchronizing system 30, improves the conventional transmitter in that the spurious waves generated in the frequency mixer 8 which fall in the transmitting band are reduced. At the same time the bandpass filter 9 can have a very simple circuit arrangement.

In a transmitter as shown in Fig. 3, the oscillation output level of the voltage controlled oscillator 33 can be kept sufficiently higher than the noise level produced or mixed therearound. Therefore, it becomes possible to substantially decrease the amplification gain of the pre-amplifier 10 and that of the power amplifier 11 such that a transmitter output 17 of improved sideband noise characteristics can be obtained by a simple construction.

Fig. 4 shows an embodiment of the present invention which is an improvement of the transmitting system described above. In the embodiment of Fig. 4, a fixed frequency divider having the frequency dividing number $N_1$ is inserted in place of the transmitting buffer amplifier 7 in the embodiment shown in Fig. 3. The frequency divider 41 is connected between the input 34 and a frequency mixer 8a. In addition, a fixed frequency divider 42 having the frequency dividing number $N_2$ is inserted in the feedback route of a transmitting phase synchronizing system 30a, and by this the bandpass filtering characteristics between the input 35a and the output 36a at the phase synchronization can be made still narrower in the bandwidth without narrowing the phase synchronizing range of the transmitting phase synchronizing system 30a, and without switching the frequency of the voltage controlled oscillator 33 in a manner ganged with the switching of the frequency dividing number $N_V$ of the variable frequency divider 33 as mentioned above.

The operation of the transmitting system of Fig. 4 will be explained for the case where $N_1=N_2=N$. The input signal $F_S$ at the input 34 is frequency divided by N times in the fixed frequency divider 41 and the output $F_S/N$ obtained is applied to the input of the frequency mixer 8a. Let us assume that the frequency mixer 8a and a bandpass filter 9a have 1/N bandwidth characteristics of the transmitting frequency bandwidth, thereby handling 1/N frequency of the frequency used in Fig. 3, and that a side step oscillator 5a and a modulator 6a are similarly to handle 1/N frequency of that shown in Fig. 3. Then, the frequency mixer 8a mixes a modulated wave output signal $F_M/N$ from the modulator 6a, which has its carrier wave at the oscillating frequency of the side step oscillator 5a, with the output $F_S/N$ from the frequency divider 41. The bandpass filter 9a selectively filters out the signal $F_S/N+F_M/N=F_T/N$, and the output of the filter 9a is fed to the input of a phase detector 31a. In addition, a part of the output signal of the voltage controlled oscillator 33 has its frequency divided by N in the fixed frequency divider 42 in the feedback route and the output signal of $F_Ta/N$ is also applied to the input of the phase detector 31a. In the phase detector 31a, the phases of the signals are compared and if $F_T/N=F_Ta/N$ is established, the loop system is now phase synchronized. Now, let us assume that the transmitting phase synchronizing system 30a is in the phase synchronizing condition, and that the input frequency $F_T/N$ of the input 35a is switched

to $(F_T+nF_C)/N$ due to switching of the channel of the phase synchronizing type digital frequency synthesizer 1. A beat signal $nF_C/N$ will instan-taneously appear at the output of the phase detector 31a, but by simply securing the loop frequency response characteristics to said range of $nF_C/N$, a narrow bandwidth of the transmission frequency bandwidth of the block 30a viewed from the input 35a to the output 36a can very easily be realized.

The transmitting system as shown in Fig. 4 may, at first glance, appear to be just a simple improvement of the system illustrated in Fig. 3 in that a frequency divider 42 has been included in the feedback route of the phase synchronizing system. However, the advantages obtained by this are unexpectedly large.

Thus, it is known that the frequency at the input 35a will be multiplied by the frequency dividing number N of the frequency divider. In addition, the modulation frequency shift of the output of the modulator 6a can be made "shallow" at 1/N of the transmitting frequency shift of the output 17. This, together with the fact that 1/N of the carrier input frequency of the modulator 6a is the output frequency of the side step oscillator 5a, means that the circuit construction of the modulator 6a can be simplified substantially as compared with that shown in Figs. 1 and 3 and at the same time the modulation characteristics are improved. The transmission frequency bandwidth of the loop 30a viewed from the input 35a to the output 36a may be more and more narrowed in proportion to an increase of the frequency dividing number N of the frequency dividers 41 and 42, but the following limitations thereto do exist. Namely, the narrowing of the bandwidth of the loop 30a must be effected in a manner such that the spectrum of the maximum frequency shift produced in the case of frequency modulation of the output frequency of the side step oscillator 5a by the modulation input signal 19 lies in a range of no bandwidth restriction.

In the circuits shown in Figs. 1 and 3, a transmitting buffer amplifier 7 is provided between the phase synchronizing type digital frequency synthesizer 1 and the frequency mixer 8. This is to prevent reverse transmission of the mixed wave of the frequency mixer 8 into the local oscillation signal of the receiver 3 which would deteriorate remarkably the characteristics of the receiver 3. In conventional FM radio equipment of the multichannel simultaneous transmitting and recieving type, it is inevitable that a buffer amplifier having large reverse transmission attenuation characteristics be provided. However in the embodiment shown in Fig. 4, the buffer amplifier 7 is omitted, and its function is performed by the fixed frequency divider 41 which prevents the reverse transmission of the waves from the frequency mixer 8a. This is a subsidiary effect of the lowering of the operating frequency of the frequency mixer 8a to 1/N, but this effect also contributes considerably.

In summary, the embodiment of the invention shown in Fig. 4 can easily overcome the disadvantages of the conventional systems, of spurious waves produced in the frequency mixer getting into the transmitting bandwidth and of sideband noises. Furthermore, by the addition of the fixed frequency dividers 41 and 42, respectively in the output of the phase synchronizing type digital frequency synthesizer 1, and in the feedback route of the transmitting phase synchronizing system 30a, the operating frequency of the side step oscillator 5a, of the modulator 6a, and of the bandpass filter 9a may be reduced to an optimum frequency considering both the operational characteristics and the manufacture thereof. In addition, as there is no narrowing of the phase synchronizing range of the transmitting phase synchronizing system, the narrow bandwidth of the loop can be realized easily without using the complicated step of intentionally switching the oscillating frequency of the voltage controlled oscillator of the transmitting phase synchronizing system in gang with the variable frequency divider of the phase synchronizing type digital frequency synthesizer. The elimination of the transmitting buffer amplifier enables further miniaturization and enconomization of the device to be achieved.

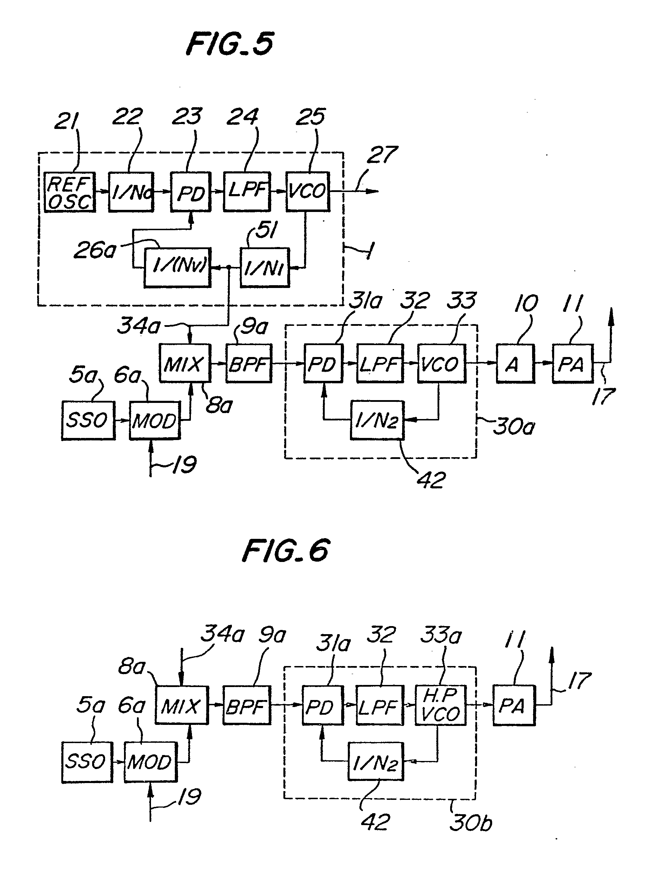

Fig. 5 shows a further embodiment of the present invention which is an improvement of the embodiment of Fig. 4.

To increase the frequency $F_S$ of the output 27 of the phase synchronizing type digital frequency synthesizer 1 shown in Fig. 2, it is necessary to make the oscillation frequency of the voltage controlled oscillator 25 high. However, the increase in frequency is restricted by the upper limit frequency response characteristics of the variable frequency divider 26. Therefore, when a high frequency is to be handled, it is usual for the variable frequency divider to be replaced by a cascade connection of a variable frequency divider and a fixed frequency divider having a high upper limit of frequency response characteristics, and by this means the input frequency of the variable frequency divider is decreased and a stable operation is obtained. Fig. 5 shows such an arrangement within the phase synchronizing type digital frequency synthesizer 1 which incorporates a fixed frequency divider 51 and a variable frequency divider 26a. In this case, if the output 34a of the fixed frequency divider 51 is applied as shown as the input to the frequency mixer 8a, the functions of the fixed frequency divider 41 of Fig. 4 can also be achieved by the fixed frequency divider 51 so that the efficiency of the power consumption as compard with that of Fig. 4 can be improved in addition to the simplification, miniaturization and econimization of the circuit. The embodiment of Fig. 5 is especially effective for devices used in higher frequency bands.

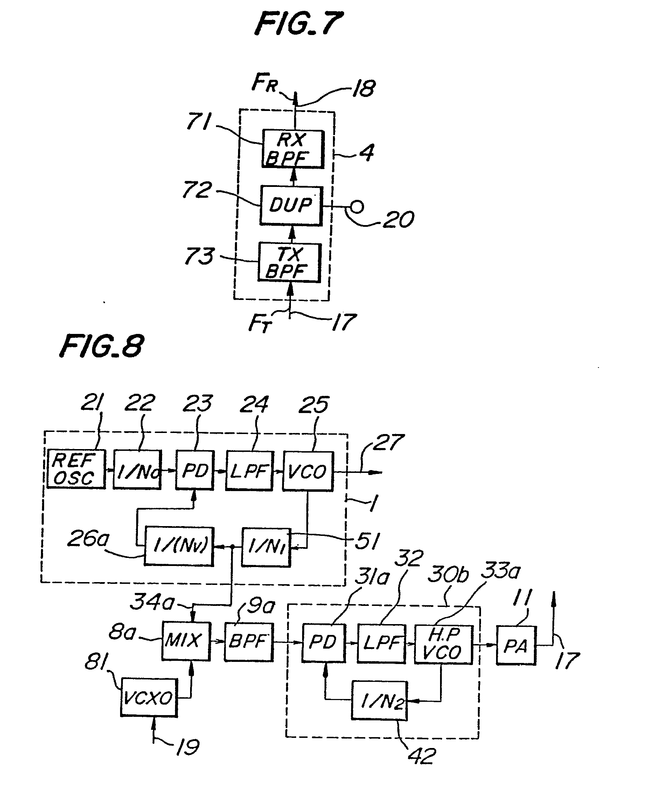

Fig. 6 shows a further embodiment of a transmitter of the present invention, in which a voltage controlled oscillator 33a of the transmitting phase synchronizing system is arranged to supply high output power able to directly drive the power amplifier 11, the oscillator 33a being a part of the loop 30b.

As is made clear above, the gain of the preamplifier 10 and of the power amplifier 11 can be decreased by increasing the oscillating output level of the voltage controlled oscillator 33, and as a result the sideband noises in the output 17 can be decreased. The embodiment shown in Fig. 6 further decreases the sideband noises. In this embodiment, the preamplifier 10 is omitted and its function is accomplished by the voltage controlled oscillator 33a. In general, low power consumption and high power output may be realized relatively easily in a voltage controlled oscillator by the selection of the optimum operating point and by the suitable selection of the active elements for the oscillation and amplification. The embodiment illustrated in Fig. 6 makes use of this feature, and when this embodiment is compared with embodiments including the preamplifier 10, the number of circuit parts is smaller and higher efficiency power consumption can be achieved. When the voltage controlled oscillator 33a is made to provide a high power output, the sideband noise characteristics thereof have a tendency to deteriorate slightly near to the oscillation output frequency as compared with a normal voltage controlled oscillator not having a high power output. However, there is a quite effective countermeasure, and by positively utilizing the feature that the phase noises of the voltage controlled oscillator at the synchronization of the phase synchronizing system are decompressed and suppressed in proportion to the magnitude of the loop gain, the sideband noises near the output frequency can be greatly suppressed.

To aid in the explanation, the construction of the antenna duplexer 4 is shown in Fig. 7.

Fig. 7 shows the antenna duplexer 4 to comprise a receiving bandpass filter 71, an antenna duplexer portion 72, and a transmitting bandpass filter 73. The transmitting bandpass filter 73 is known per se and is known to decrease transmission of spurious waves and sideband noises outside the transmitting band from the antenna terminal 20.

In FM radio equipment of the simultaneous transmission and receiving type, it is usual to have respective bands of the transmission frequency $F_T$ and the receiving frequency $F_R$. In this case the sideband noises of the transmitting output signal may tend to get into the receiving frequency band and thus to cause deterioration of the characteristics of the receiver.

In the transmitting bandpass filter 73, noises that do get into the receiving frequency bandwdith should be sufficiently suppressed. However, it is required to keep the losses of the bandpass filter 73 as small as possible as compared to the transmitting output to therbey make the loss in the transmission band small. Furthermore since good receiving characteristics are required where the transmitting and receiving bands are mutually arranged very close to each other, a large attentuation of the receiving band is desirable. In these circumstances, the transmitting bandpass filter 73 should be highly accurate and have a large capability.

For this reason, a multistage cascade connection of low loss resonators of high cost is generally used. On the other hand as explained with reference to Fig. 6, when a high power voltage controlled oscillator 33a is used, the sideband noise level at the outside of the transmission band is already very low per se, so that the sideband noises may be sufficiently suppressed without the use of an expensive transmitting bandpass filter 73.

Thus, it may be possible, for instance, to decrease the numbers of steps in the cascade combination of resonators and as a result, the fine adjustment required in the conventional filters is no longer necessary, so that a compact, light weight, economical and a low forward loss transmitter can be obtained.

The circuit construction shown in Fig. 6 can only be realized by the introduction of the transmitting phase synchonizing system, and the aforementioned advantages could never be obtained by the conventional construction as shown in Fig. 1 or by similar constructions.

Fig. 8 shows an embodiment incorporating an improvement of the modulator in the transmitter. As was explained when referring to Figs. 4 and 5, the oscillating output of the side step oscillator 5a is used as the carrier wave input signal, and this signal is modulated in the modulator 6a by the modulating input signal 19 a modulated wave output signal being derived at the output of the modulator 6a. Usually a crystal oscillator is used for the side step oscillator 5a, and generally the modulator 6a is formed by a phase modulation circuit of a vector composite or variable reactance system. When using these kinds of devices to widen the frequency range of the modulating input signal 19 down to the lower frequency range (as is required in a system of the invention), for instance, to the range 20 Hz to 3KHz, good modulation characteristics with low distortion are required and a circuit including a great many parts capable of being finely adjusted may be required. In view of this, in the embodiment of Fig. 8, a voltage controlled crystal oscillator 81 is used in place of both the side step oscillator 5a and the modulator 6a, and the modulating input signal 19 is applied to the oscillator 81 as its controlling input signal. This has the advantage of obtaining a good modulated FM wave at its output by a relatively simple construction.

In fact the construction shown in Fig. 8 can only by realized by the introduction or insertion of the transmitting phase synchronizing system 30a for the reason explained below. In general, when a voltage controlled crystal oscillator is used as an FM modulator, it is required to keep the modulation sensitivity (frequency shift of the output signal against the modulating input signal level) high in order to obtain a good quality modulated FM wave (having flat frequency shift and low distortion factor over a wide modulating input frequency). To achieve this it has previously been necessary to insert an inductance in series with the crystal oscillator (or the crystal resonator) and to use the reactance of the crystal oscillator (or crystal resonator) in a capacitive range or near to it, or else to use a high sensitivity voltage variable element (or current variable element) such as a voltage variable capacitive element. However, when these methods have been used, the stability of the oscillation frequency has deteriorated because of an increase in the modulation sensitivity caused by variations in environmental conditions such as temperature variations, source voltage variations, variations due to ageing in parts forming the voltage controlled crystal oscillator, and the like. Among the above factors, the temperature variation has the most influence, and conventional methods for obtaining both a high modulation sensitivity and a high stabilization of the oscillation frequency usually involve either the addition of a control circuit for temperature compensation in the frequency controlling circuit of the modulation input or placing the voltage controlled crystal oscillator into a thermostatic bath or the like. However, with these methods, the number of parts or the labour required to make the adjustments may increase so that these methods are not suitable where it is intended that the device be economical and miniaturized.

In Fig. 8, the transmitting phase synchronization system 30a is included in the circuit, and by its multiplying function, the frequency shift of the modulated FM wave of the voltage controlled crystal oscillator 81 may be decreased to 1/N of the frequency shift of the transmitting output $F_T$. Accordingly, the circuit of the voltage controlled crystal oscillator 81 is simplified and the oscillating output frequency achieves high stability.

The frequency shift of the transmitting output 17 is determined by the frequency stability of both the reference oscillator 21 of the phase synchronizing type digital frequency synthesizer 1 and of the side step oscillator 5 in Figs. 1 and 3 or of the side step oscillator 5a in Figs. 4, 5 and 6 which is replaced by the voltage controlled crystal oscillator 81 in Fig. 8. When strict requirements for the transmitting output frequency shift exist, a more stringent requirement for the frequency stability of the oscillators is necessary. However, this more stringent requirement contains the inherent possibility that the devices will become very expensive. This is a general problem and already exists in the usual known tarnsmitters.

In order to solve this problem in a device using a side step oscillator and a modulator, it is possible to obtain a high stability of the transmitting output frequency by a known transmitting method, in which a modulation phase output system is added to replace the above devices, see for example, Japanese Laid-Open Patent Application Number 53-41,916 "Transmitting device in frequency modulating system".

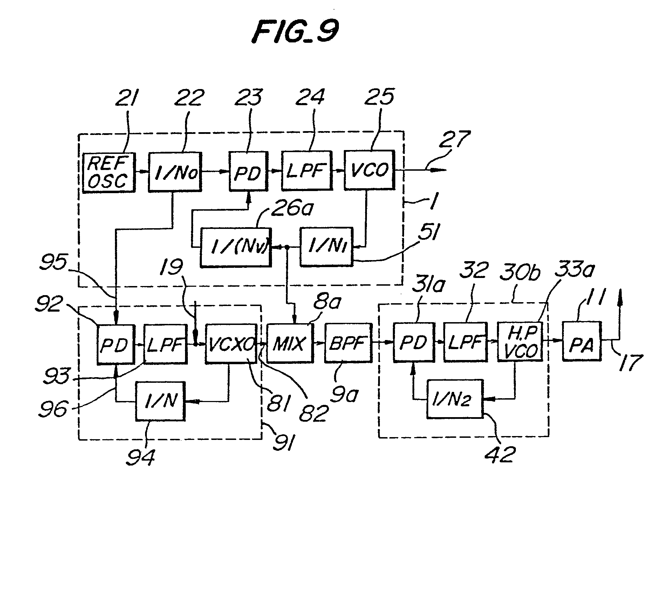

Fig. 9 shows an improvement of the embodiment of Fig. 8 and is one method of solving the problem when using the voltage controlled crystal oscillator. This method can be carried out either by branching out the output signal of the reference oscillator 21 or by deriving an interstep output signal from the fixed frequency divider 22 of which the frequency dividing number is an integer (in general it is a rational number) and by branching it (Fig. 9 shows the latter) and introducing a new modulating phase synchronizing loop 91 having the derived signal as the reference frequency.

In operation of this loop 91 a phase detector 92 compares a reference frequency 95, derived in the manner just described, with a signal 96 which is part of the output signal of the voltage controlled crystal oscillator 81 whose frequency has been divided by a fixed frequency divider 94. An output of the phase detector 92 is passed through a lowpass filter 93 and then fed to an input of the voltage controlled oscillator 81 and the resulting output is fed back to the frequency divider 94 such that a feedback control is established. Accordingly, the output frequency 82 is controlled by the reference frequency 95.

By this method, the frequency deviation of the transmitting output 17 is determined by the quality of the output frequency 82 so that high stabilization of the frequency and hence low cost of the device is possible. By using a known modulation method (Japanese Laid-Open Patent Application Number 52-93,261 "Frequency modulation system"), in which the modulating input signal 19 is superposed on a control signal between the lowpass filter 93 and the voltage controlled crystal oscillator 81, the modulated signal is easily derived from the voltage controlled crystal oscillator 81. The modulation characteristics thereof become FM modulation characteristics over the cutoff frequency due to the frequency response characteristics of the closed loop system, and become phase modulation characteristics below said cutoff frequency. If an FM modulation wave is derived at the output of the voltage controlled crystal oscillator 81, this cutoff frequency of the closed loop system may be set at a value lower than the lower limit frequency of the modulation input signal 19.

In the circuit of Fig. 9, in which the modulating phase synchronizing system is used in the transmitter, higher stabilization of the frequency of the transmitting output can easily be realized as compared to the conventional arrangement using a side step oscillator shown in Fig. 1, the arrangements of Fig. 3 and of the present invention shown in Figs. 4, 5 and 6 or that shown in Fig. 7, in which the voltage controlled crystal oscillator is simply used as an FM oscillator. Further, since the frequency deviation of the transmitting output is deterministically decided only by the reference oscillation of the phase synchronizing type digital frequency synthesizer, the frequency adjustment is made at the time of manufacture of the devices and maintenance by the user become easy, and this means that an overall decrease in the cost of the device is achieved.

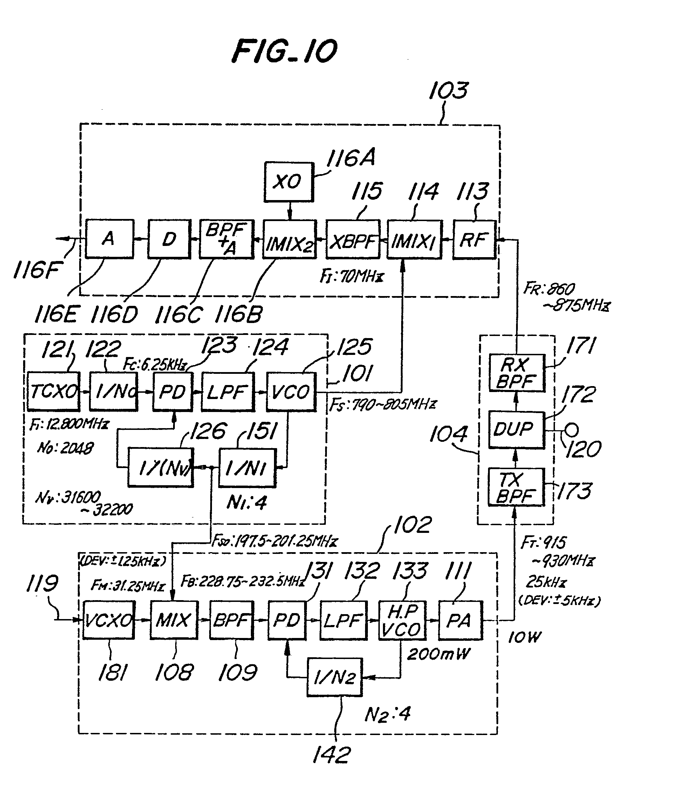

Fig. 10 is a practical embodiment of a 800 MHz band multichannel FM radio device of a simultaneous transmitting and receiving system incorporating a transmitter as shown in Fig. 8, and giving the practical values for the frequency dividing numbers and the frequencies of various parts.

Fig. 10 shows a phase synchronizing type digital frequency synthesizer 101, a transmitter 102, a receiver 103, and an antenna duplexer 104.

The frequency synthesizer 101 comprises a series connection of a crystal oscillator 121 of temperature compensation type, a fixed frequency divider 122, a phase detector 123, a lowpass filter 124, and a voltage controlled oscillator 125. A fixed frequency divider 151 and a variable frequency divider 126 feed back the output of the oscillator 125 to the phase detector 123. The transmitter 102 comprises a serial connection of a voltage controlled crystal oscillator 181 receiving a modulating input 119, a frequency mixer 108, a bandpass filter 109, a phase detector 131, a lowpass filter 132, a high output voltage controlled oscillator 133, and a power amplifier 111. A fixed frequency divider 142 feeds back the output at the oscillator 133 to the phase detector 131.

The receiver 103 comprises a series connection of a receiver high frequency portion 113, an intermediate frequency converter 114, a crystal bandpass filter 115, a further intermediate frequency converter 116B, a bandpass filter and amplifier 116C, an FM demodulator 116D, and a remodulated output 116E connected to an output 116F. A crystal oscillator 116A is connected to the further intermediate frequency converter 116B.

The antenna duplexer 104 comprises a series connection of a transmitting bandpass filter 173, an antenna duplexer portion 172, and a receiving bandpass filter 171. An antenna terminal 120 is connected to the duplexer portion 172. The embodiment illustrated is a 600 channel FM radio equipment of simultaneous transmitting and receiving system with a 25 KHz channel interval.

The voltage controlled crystal oscillator 181 has an oscillation frequency of 31.25 MHz and it also functions as an FM modulator. The maximum frequency shift or deviation of the modulated wave appearing at the output of the oscillator 181 is ±1.25 KHz, which is 1/4 of the requested output frequency deviation ±5 KHz of $F_T$. The passband width B of the bandpass filter 109 is 3.75 MHz, which is 1/4 of the requested bandwidth 15 MHz of the $F_T$. The phase detector 131, the lowpass filter 132, the high output power voltage controlled oscillator 133, and the fixed frequency divider 142 form the transmitting phase synchronizing system and have a cutoff frequency of about 4MHz for the closed loop circuit. The spurious waves and the sideband noises still remainining in the signal even after selected filtering by the bandpass filter 109 are further selectively suppressed in this synchronizing system and at the same time the noises near the high output power voltage controlled oscillator 133 are suppressed. The high output power controlled oscillator 133 has a high power output over 200 mW, and the power amplifier 111 is directly driven by its output and a power of 10 W can be obtained. The transmitting bandpass filter 173 in the antenna duplexer 104 had been formed in conventional devices by three step or four step resonators. However, in the present embodiment, it may be formed by a two-step device and by this sideband noises getting into the receiver 103 can be sufficiently suppressed and decreased. The frequency deviation of the transmitting output $F_T$ can be maintained within a range of $\pm2.5$ PPM by keeping the frequency stability of the temperature compensating crystal oscillator 121 within $\pm2.0$ PPM and the frequency stability of the voltage controlled frequency oscillator 181 within $\pm5.0$ PPM.

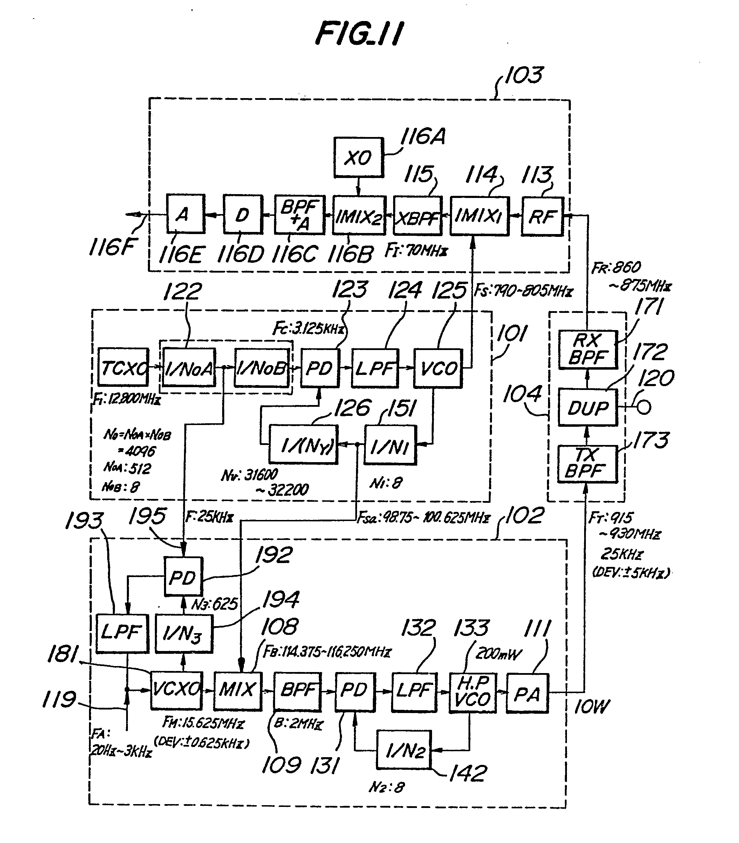

Fig. 11 shows a further practical embodiment of a 800 MHz band multichannel simultaneous transmitting and receiving system FM radio device incorporating the transmitter of Fig. 9 and giving practical values for the frequency dividing numbers and frequency relationships.

The embodiment of Fig. 11 is similar to that of Fig. 10, and the same reference numerals are used in each of these figures to refer to similar parts. In addition, in the embodiment of Fig. 11, the transmitter 102 includes a modulating phase synchronizing system for the voltage controlled crystal oscillator 181. This modulating phase synchronizing system comprises a fixed frequency divider 194 a phase detector 192 and a lowpass filter 193. The phase detector 192 receives, as an input to the modulating phase synchronizing system, a reference frequency of 25 KHz derived from an output 195 of the phase synchronizing type digital frequency synthesizer 101. The synchronizing system phase controls the oscillation frequency of 15.625 MHz of the voltage controlled crystal oscillator 181 and produces a modulated FM wave by arranging the loop cutoff frequency to be less than 20Hz. By arranging the frequency dividing number of the fixed frequency dividers 151 and 142 to be 1 and 8 respectively, the maximum frequency deviation of the voltage controlled crystal oscillator 181 is $\pm0.625$ KHz, the passband width B of the bandpass filter 109 is 2 MHz, and the close loop cutoff frequency of the transmitting phase synchronizing system is 2MHz, the transmitting phase synchronizing system being formed by the phase detector 131, the lowpass filter 132, the high output power voltage controlled oscillator 133 and the fixed frequency divider 142. The frequency deviation of the transmitting output $F_T$ can be kept as $\pm2.0$ PPM, that is, the same as the frequency stability of the temperature compensating type crystal oscillator 121.

As has been explained above, in conventional multichannel simultaneous transmitting and receiving system FM radio equipment, spurious waves are produced in the frequency mixer of the transmitter which interfere with the transmitting bandwidth and some filtering out practices for preventing this are required. Known circuit arrangements for suppressing and removing the sideband noises and the like are particularly complicated and usually require an increase in the number of parts and they need to be adjusted, and inevitably this increases the cost of such arrangements. These factors have hindered the miniaturization of the devices and have prevented savings in power consumption. The systems of the present invention described above overcome all these disadvantages as has been explained.

All the embodiments described above have been related to a multichannel simultaneous transmitting and receiving system FM radio device, but the present system is not limited to such a system and it is apparent that the invention can be utilized in a normal FM transmitter.

**Claims**

1. A transmitter comprising a frequency mixer (8a, 108) to one input of which is applied a frequency input signal, and to another input of which is applied an output of phase or frequency modulating means (5a, 6a; 81, 181), the output from said frequency mixer (8a, 108) being coupled to amplifying means (10, 11, 111) by way of a bandpass filter (9a, 109), and wherein a phase synchronizing system (30a, 30b) is connected between said bandpass filter and said amplifying means, said phase synchronizing system comprising a phase detector (31a, 131) coupled to a voltage controlled oscillator (33, 33a, 133) and having a feedback route from said voltage controlled oscillator to said phase detector; characterized in that said frequency input signal is an output of a phase synchronizing type digital frequency synthesizer (1, 101), in that the phase synchronizing system comprises a series connection of the phase detector (31a, 131), a lowpass filter (32, 132) and the voltage controlled oscillator (33, 33a, 133), the phase detector being connected to the bandpass filter (9a, 109) and the voltage controlled oscillator being connected to the amplifying means (10, 11, 111), in that a first fixed frequency divider (41, 51, 151) is connected between said phase synchronizing type digital frequency synthesizer (1, 101) and said frequency mixer (8a, 108), and in that a second fixed frequency divider (42, 142) is connected in the feedback route of said phase synchronizing system (30a, 30b).

2. A transmitter as claimed in Claim 1, characterized in that the phase synchronizing type digital frequency synthesizer (1, 101) comprises a series connection of a reference oscillator (21, 121), a fixed frequency divider (22, 122), a phase detector (23, 123), a lowpass filter (24, 124) and a voltage controlled oscillator (25, 125), and in that a feedback route from the voltage controlled oscillator (25, 125) to said phase detector (23, 123) is provided, said feedback route being formed by a series connection of said first fixed frequency divider (41, 51, 151) and a variable frequency divider (26a, 126), the connection between the output of the first fixed frequency divider (41, 51, 151) and the input to the variable frequency divider (26a, 126) being connected to said frequency mixer (8a, 108).

3. A transmitter as claimed in Claim 2, characterized in that a second output of the fixed frequency divider (22, 122) of said frequency synthesizer is applied to said modulating means (181), and in that said modulating means comprises a series connection of a phase detector (192) to which the output from the frequency synthesizer is applied, a lowpass filter (193), and a voltage controlled crystal oscillator (181), and in that a feedback route comprising a further fixed frequency divider (194) connects the voltage controlled crystal oscillator (181) to the phase detector (192).

4. A transmitter as claimed in Claim 1 or 2, wherein said phase or frequency modulating means comprises a phase or frequency modulator (6a) connected in series to a side step oscillator (5a).

5. A transmitter as claimed in Claim 1 or 2, wherein said phase or frequency modulating means comprises a voltage controlled crystal oscillator (81, 181).

6. A transmitter as claimed in any preceding claim, wherein said voltage controlled oscillator of said phase synchronizing system (30a, 30b) is a high output power oscillator (33a, 133).

7. A transmitter as claimed in any preceding claim, wherein said amplifying means comprises simply a power amplifier (11, 111).

8. A transmitter as claimed in any of Claims 1 to 6, wherein said amplifying means comprises a pre-amplifier (10) in series with a power amplifier.

**Patentansprüche**

1. Sender mit einem Frequenzmischer (8a, 108), an dessen einen Eingang ein Frequenzeingangssignal und an dessen anderen Eingang ein Ausgang einer Phasen- oder Frequenzmodulationsvorrichtung (5a, 6a; 81, 181) angelegt wird, wobei der Ausgang des Frequenzmischers (8a, 108) über ein Bandpassfilter (9a, 109) mit Verstärkungsvorrichtungen (10, 11, 111) verbunden ist und worin ein Phasensynchronisiersystem (30a, 30b) zwischen das Bandpassfilter und die Verstärkervorrichtung geschaltet ist, das Phasensynchronisiersystem einen Pahsendetektor (31a, 131) umfaßt, der mit einem spannungsgesteuerten Oszillator (33, 33a, 133) verbunden ist und einen Rückkopplungspfad vom spannungsgesteuerten Oszillator zum Phasendetektor aufweist, dadurch gekennzeichnet, daß das Frequenzeingangssignal ein Ausgang eines digitalen phasensynchronisierenden Frequenzsynthesizers (1, 101) ist, daß das Phasensynchronisiersystem eine Reihenschaltung aus dem Phasendetektor (31a, 131), einem Tiefpassfilter (32, 132) und dem spannungsgesteuerten Oszillator (33, 33a, 133) aufweist, wobei der Phasendetektor mit dem Bandpassfilter (9a, 109) verbunden ist und der spannungsgesteuerte Oszillator mit der Verstärkungsvorrichtung (10, 11, 111), daß ein erster fester Frequenzteiler (41, 51, 151) zwischen den phasensynchronisierenden digitalen Frequenzsynthesizer (1, 101) und den Frequenzmischer (8a, 108) geschaltet ist und daß ein zweiter fester Frequenzteiler (42, 142) in den Rückkopplungspfad des Phasensynchronisiersystems geschaltet ist.

2. Sender nach Anspruch 1, dadurch gekennzeichnet, daß der phasensynchronisierende digitale Frequenzsynthesizer (1, 101) eine Reihenschaltung aus einem Bezugsoszillator (21, 121), einem festen Frequenzteiler (22, 122), einem Phasendetektor (23, 123), einem Tiefpassfilter (24, 124) und einem spannungsgesteuerten Oszillator (25, 125) umfaßt, und daß ein Rückkopplungspfad vom spannungsgesteuerten Oszillator (25, 125) zum Phasendetektor (23, 123) vorgesehen ist, wobei der Rückkopplungspfad aus einer Reihenschaltung des ersten festen Frequenzteilers (41, 51, 151) und eines variablen Frequenzteilers (26a, 126) besteht und die Verbindung zwischen dem Ausgang des ersten festen Frequenzteilers (41, 51, 151) und dem Eingang des variablen Frequenzteilers (26a, 126) mit dem Frequenzmischer (8a, 108) verbunden ist.

3. Sender nach Anspruch 2, dadurch gekennzeichnet, daß ein zweiter Ausgang des festen Frequenzteilers (22, 122) des Frequenzsynthesizers den Modulationsvorrichtungen (181) zugeführt ist, und daß die Modulationsvorrichtungen eine Reihenschaltung aus einem Phasendetektor (192), dem der Ausgang des Frequenzsynthesizers zugeführt wird, einem Tiefpassfilter (193) und einem spannungsgesteuerten Oszillator (181) enthält, und daß ein Rückkopplungspfad mit einem weiteren festen Frequenzteiler (194) den spannungsgesteuerten Oszillator (181) mit dem Phasendetektor (192) verbindet.

4. Sender nach Anspruch 1 oder 2, bei dem die Phasenoder Frequenzmodulationsvorrichtung einen Phasen- oder Frequenzmodulator (6a) umfaßt, der in Reihe mit einem Ein-Stufenoszillator (5a) geschaltet ist.

5. Sender nach Anspruch 1 oder 2, bei dem die Phasen- oder Frequenzmodulationsvorrichtung einen spannungsgesteuerten Kristalloszillator (81, 181) umfaßt.

6. Sender nach einem der vorstehenden Ansprüche, bei dem der spannungsgesteuerte Oszillator des Phasensynchronisiersystems (30a, 30b) ein Oszillator (33a, 133) mit hoher Ausgangsleistung ist.

7. Sender nach einem der vorstehenden Ansprüche, bei dem die Verstärkungsvorrichtung nur einen Leistungsverstärker (11, 111) aufweist.

8. Sender nach einem der Ansprüche 1 bis 6, bei dem die Verstärkungsvorrichtung einen Vorverstärker (10) aufweist, der in Reihe mit einem Leistungsverstärker geschaltet ist.

**Revendications**

1. Emetteur comprenant un mélangeur de fréquences (8a, 108) sur une entrée duquel est appliqué un signal d'entrée de fréquence et sur une autre entrée duquel est appliquée une sortie de moyens de modulation de phase ou de fréquence (5a, 6a; 81, 181), la sortie dudit mélangeur de fréquences (8a, 108) étant reliée à des moyens d'amplification (10, 11, 111) par l'intermédiaire d'un filtre passe-bande (9a, 109), et dans lequel un système de synchronisation de phases (30a, 30b) est relié entre ledit filtre passe-bande et lesdits moyens d'amplification, ledit système de synchronisation de phases comprenant und détecteur de phase (31a, 131) relié à un oscillateur commandé par la tension (33, 33a, 133) ayant un trajet de réaction allant dudit oscillateur commandé par la tension audit détecteur de phase; caractérisé en ce que ledit signal d'entrée de fréquence est une sortie d'un synthétiseur de fréquence numérique de type à synchronisation de phase (1, 101), en ce que le systéme de synchronisation de phase comprend, montés en série, le détecteur de phase (31a, 131), un filtre passe-bas (32, 132) et l'oscillateur commandé par la tension (33, 33a, 133), le détecteur de phase étant relié au filtre passe-bande (9a, 109) et l'oscillateur commandé par la tension étant relié aux moyens d'amplification (10, 11, 111), en ce qu'un premier diviseur de fréquence fixe (41, 51, 151) est relié entre le synthétiseur de fréquence numérique de type à synchronisation de phase (1, 101) et ledit mélangeur de fréquences (8a, 108), et en ce qu'un second diviseur de fréquence fixe (42, 142) est monté sur le trajet de réaction dudit système de synchronisation de phase (30a, 30b).

2. Emetteur selon la revendication 1, caractérisé en ce que le synthétiseur de fréquence numérique de type à synchronisation de phase (1, 101) comprend, monté en série, un oscillateur de référence (21, 121), un diviseur de fréquence fixe (22, 122), un détecteur de phase (23, 123), un fitlre passe-bas (24, 124) et un oscillateur commandé par la tension (25, 125), et en ce qu'un trajet de réaction allant de l'oscillateur commandé par la tension (25, 125), au détecteur de phase (23, 123) est prévu, ledit trajet de réaction étant constitué par, montés en série, ledit premier diviseur de fréquence fixe (41, 51, 151) et un diviseur de fréquence variable (26a, 126), la liaison entre la sortie du premier diviseur de fréquence fixe (41, 51, 151) et l'entrée du diviseur de fréquence variable (26a, 126) étant reliée audit mélangeur de fréquence (8a, 108).

3. Emetteur selon la revendication 2, caractérisé en ce qu'une seconde sortie du diviseur de fréquence fixe (22, 122) dudit synthétiseur de fréquence est appliquée aux moyens de modulation (181), et en ce que lesdits moyens de modulation comprennent, montés en série, un détecteur de phase (192) sur lequel est appliquée la sortie du synthétiseur de fréquence, un filtre passe bas (193), et un oscillateur à cristal commandé par la tension (181), et en ce qu'un trajet de réaction comprenant un autre diviseur de fréquence fixe (194) relie l'oscillateur à cristal commandé par la tension (181) au détecteur de phase (192).

4. Emetteur selon la revendication 1 ou 2, dans lequel lesdits moyens de modulation de phase ou de fréquence comprennent un modulateur de phase ou de fréquence (6a) monté en série avec un oscillateur "side-step" (5a).

5. Emetteur selon la revendication 1 ou 2, dans lequel lesdits moyens de modulation de phase ou de fréquence comprennent un oscillateur à cristal commandé par la tension (81, 181).

6. Emetteur selon l'une quelconque des revendications précédentes dans lequel ledit oscillateur commandé par la tension dudit système de synchronisation de phase (30a, 30b) est un oscillateur à rendement élevé (33a, 133).

7. Emetteur selon l'une quelconque des revendications précédentes, dans lequel les moyens d'amplification comprennent simplement un amplificateur de puissance (11, 111).

8. Emetteur selon l'une quelconque des revendications 1 à 6 dans lequel les moyens d'amplification comprennent un préamplificateur (10) en série avec un amplificateur de puissance.

## FIG_1

## FIG_2

# FIG.3

# FIG.4

## FIG_5

21 22 23 24 25

27

| REF OSC | 1/Nₐ | PD | LPF | VCO |

26a → 1/(Nv) ← 51 → 1/N₁

34a

31a 32 33 10 11

17

MIX → BPF → PD → LPF → VCO → A → PA

5a 6a

SSO → MOD

8a

9a

1/N₂

30a

19

42

## FIG_6

34a 9a 31a 32 33a 11

8a

17

5a 6a MIX → BPF → PD → LPF → H.P VCO → PA

SSO → MOD

1/N₂

19

42 30b

## FIG.7

## FIG.8

# FIG. 9

# FIG_10

103

116A

XO

115 114 113

116F → A — D — BPF +A — IMIX₂ — XBPF — IMIX₁ — RF

$F_I: 70MHz$

116E 116D 116C 116B

121 122 $F_C: 6.25kHz$ 123 124 125

101

TCXO — I/N₀ — PD — LPF — VCO

$F_i: 12.800MHz$

$N_0: 2048$

$F_S: 790~805MHz$

126 151

I/(N_V) — I/N₁

$N_V: 31600~32200$

$N_1: 4$

$F_R: 860~875MHz$

171

RX BPF

172

DUP — ○ 120

104

TX BPF — 173

$F_{S0}: 197.5~201.25MHz$

102

$(DEV: ±125kHz)$

119

$F_M: 31.25MHz$ $F_B: 228.75~232.5MHz$ 131 132 133 111

VCXO — MIX — BPF — PD — LPF — H.P VCO — PA

181 108 109

I/N₂

200mW

$N_2: 4$

142

$F_T: 915~930MHz$

25kHz

$(DEV: ±5kHz)$

10W

# FIG.11